# EUROPEAN PATENT APPLICATION

(11) **EP 4 703 112 A1**
(43) Date of publication of application: **04.03.2026**
(21) Application number: 24197897.2
(22) Date of filing: 02.09.2024
(51) Int. Cl.: B29B 17/02, C08J 11/08, H05K 3/22, H05K 3/28

(54) **RECYCLING, MANUFACTURING AND REPAIR OF ELECTRONIC STACK**

(71) Applicant: Nederlandse Organisatie voor toegepast- natuurwetenschappelijk onderzoek TNO, 2595 DA 's-Gravenhage (NL)
(72) Inventor: HARKEMA, Stephan, 2595 DA ´s-Gravenhage (NL)
(74) Representative: V.O.

(57) **Abstract**

An electronic stack (10) comprises a substrate layer (11) formed of a first plastic material, a circuit layer (15) formed of a metal material arranged on the substrate layer (11), and an encapsulation layer (12) formed of a second plastic material covering the circuit layer (15) embedded between the substrate layer (11) and the encapsulation layer (12). Together the layers form a recyclable package (P). A support layer (13) formed of a third plastic material covers the recyclable package (P). A dissolving agent (A) is formulated to dissolve the third plastic material (13m) while essentially leaving the first plastic material and the second plastic material intact. The dissolving agent (A) is applied to the electronic stack (10) for removing the support layer (13) and isolating the recyclable package (P) comprising the circuit layer (15) embedded between the substrate layer (11) and the encapsulation layer (12).

## Description

### TECHNICAL FIELD AND BACKGROUND

The present disclosure relates to a method of recycling, manufacturing, and repairing an electronic stack, in particular an electronic stack manufactured for recycling and repair.

Recycling electronics that are fused with plastics presents significant challenges. Typically, there are significant losses associated with either the plastics or the metals during the recycling process. Ideally, plastics, metals and surface-mounted device (SMD) components should be recovered separately to maximize material recovery.

While physical recycling of certain plastics by dissolution is highly effective, it can result in losses of printed metals on the surface, which is particularly problematic for precious metals that contribute significantly to the economics of recycling processes. In contrast, metal recycling typically involves physical separation techniques such as shredding, magnetic separation and eddy current separation, followed by smelting and refining to purify the recovered metals. However, these methods degrade plastics, which, unlike metals, cannot withstand high temperatures. The presence of plastics in electronic devices reduces the concentration of metals and increases the caloric value of the electronic device, thereby reducing the attractiveness and economic value of recycling. In addition, the presence of plastics compromises the repairability of the electronic components within the electronic devices.

There remains a need to improve the recyclability and repairability of electronic devices.

### SUMMARY

Aspects of the present disclosure relate to a method of recycling an electronic stack comprising a substrate layer formed of a first plastic material, a circuit layer formed of a metal material arranged on the substrate layer, and an encapsulation layer formed of a second plastic material covering the circuit layer. The circuit layer is embedded between the substrate layer and the encapsulation layer to form a recyclable package. A support layer formed of a third plastic material covers at least one side of the recyclable package.

Advantageously, by applying a dissolving agent to the electronic stack, the support layer can be removed and/or the recyclable package comprising the circuit layer embedded between the substrate layer and the encapsulation layer can be isolated. In particular, by selecting and/or formulating the dissolving agent in relation to selection/formulation of the respective plastic materials, the third plastic material may be dissolved without dissolving the first and/or second plastic materials.

Advantageously, by embedding the circuit layer between the substrate layer and the encapsulation layer, integrity of the circuit layer formed of the metal material can be preserved in the recyclable package, thereby preventing contamination of the metal material with other materials of the electronic stack, e.g. the third plastic material of the support layer, and, vice versa, preventing contamination of the other material with the metal material.

By recycling the third plastic material of the electronic stack using a low-temperature recycling method, e.g. dissolution, prior to the metal recycling, concentration of the metal material in the recyclable package can be increased, thereby providing for higher purity of metal material recycled from the isolated recyclable package. The higher the weight percentage of the metal material, the higher the purity of the recycled metal material and the higher the attractiveness and economic value of recycling the electronic stack.

By removing the third plastic material from the recyclable package, the package volume can be reduced, allowing a plurality of recyclable packages containing the valuable metal material to be processed in a single processing step, preferably a thermal processing step, thereby increasing the processing capacity and enhancing the efficiency of recycling a plurality of electronic stacks.

Advantageously, by providing the electronic stack with a reinforcement layer comprising a dissolvable fourth plastic material, recyclability of the electronic stack can be improved because the thickness of the substrate layer formed of the non-dissolvable first plastic material arranged on the reinforcement layer can be reduced. By co-extruding the non-dissolvable material of the substrate layer with a dissolvable material to form the reinforcement layer, structural integrity of the recyclable package can be improved while lowering the amount of non-dissolvable material in the recyclable package and/or the electronic stack. Same effect may also be realized with overmolding at a later stage of product development. For example, a substrate layer formed of a non-dissolvable Polyethylene Terephthalate (PET) or Polyethylene Naphtalate (PEN) material overmolded with Polycarbonate (PC) material is stronger than a layer of the same thickness formed only of the non-dissolvable Polyethylene Terephthalate (PET) or Polyethylene Naphtalate (PEN) material. A co-extruded Polycarbonate (PC) with an extra layer of Poly(methyl methacrylate) (PMMA) will also be stronger than the separate PC foil. By at least partially forming the reinforcement layer of a material having the same solubility in a respective solvent as the material of the support layer, a portion of the reinforcement layer can be removed together with the support layer using the same dissolving agent.

By applying the substrate layer and/or the encapsulation layer as a printed coating and/or thin film, the thickness of the respective layer can be accurately controlled and/or reduced to a minimum needed for maintaining the structural integrity of the circuit layer embedded between the substrate layer and the encapsulation layer.

Advantageously, by providing a third plastic material and/or fourth plastic material between additional layers (e.g. decorative, tactile, or anti-scratch layers) and the recyclable package, the recyclability of the metal material from the recyclable package can be maintained because the additional layers will separate from the recyclable package upon application of the dissolving agent to the electronic stack.

Advantageously, by isolating the recyclable package from the support layer and/or the reinforcement layer using the dissolving agent, the surface-mounted-devices disposed on the circuit layer can be repaired. The repaired recyclable package can then again be covered and/or over-molded by the respective material to restore the removed respective layer;

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A-1C illustrate a method of recycling an electronic stack;
FIGs 2A-2C illustrate a method of recycling an electronic stack comprising a reinforcement layer; and
FIGs 3A-3E illustrate a method of manufacturing an electronic stack.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

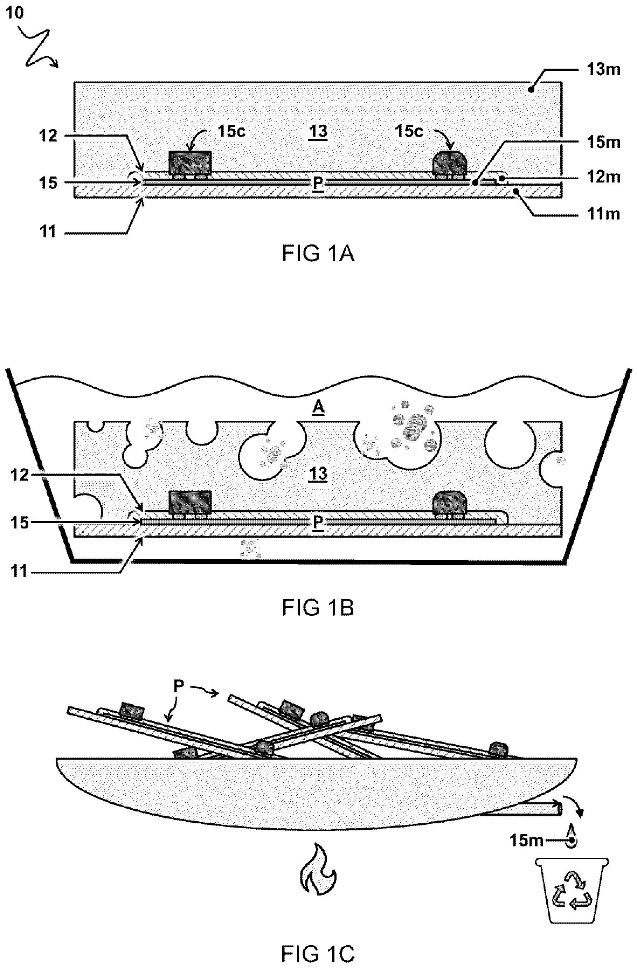

FIGs 1A-1C illustrate a method of recycling an electronic stack 10 comprising a substrate layer 11 formed of a first plastic material 11m, a circuit layer 15 formed of a metal material 15m arranged on the substrate layer 11, and an encapsulation layer 12 formed of a second plastic material 12m covering the circuit layer 15. The circuit layer 15 is embedded between the substrate layer 11 and the encapsulation layer 12 to form a recyclable package P. A support layer 13 is formed of a third plastic material 13m covering at least one side of the recyclable package P. A dissolving agent A formulated to dissolve the third plastic material 13m while essentially leaving the first plastic material 11m and the second plastic material 12m intact, e.g. as illustrated in FIG 1B, is provided. The dissolving agent A is applied to the electronic stack 10 for removing the support layer 13 and isolating the recyclable package P comprising the circuit layer 15 embedded between the substrate layer 11 and the encapsulation layer 12.

In some embodiments, the encapsulation layer 12 covers surface-mounted-devices 15c disposed on the circuit layer 15. In one embodiment, the recyclable package P comprises the surface-mounted-devices 15c. Alternatively, or in addition, the surface-mounted-devices 15c are removed prior to recycling the recyclable package P.

In some embodiments, the first plastic material 11m and the second plastic material 12m are substantially the same materials, e.g. having the same solubility in a dissolving agent A. Alternatively, or in addition, the first plastic material 11m and the second plastic material 12m are different materials having a comparable solubility in the respective dissolving agent A. In one embodiment, the first plastic material 11m and/or the second plastic material 12m has a first solubility S1 in a respective dissolving agent A. In another or further embodiment, the third plastic material 13m has a second solubility S2 in the respective dissolving agent A. Preferably, the second solubility S2 is higher as compared to the first solubility S 1, e.g. a factor of two, ten, hundred or more higher. Alternatively, or in addition, the first plastic material 11m and/or the second plastic material 12m are essentially insoluble in the respective dissolving agent A.

Preferably, the first plastic material 11m and/or the second plastic material 12m comprises at least one of Polyacrylate, Polyurethane (PU), Poly(methyl methacrylate) (PMMA) and Polyesters, including e.g. Polybutylene Terephthalate (PBT), Polyethylene Terephthalate (PET), Polyethylene Napthalene (PEN). Alternatively, or in addition, other plastic materials having a lower solubility in the respective dissolving agent A as compared to the third plastic material 13m can be envisioned.

Preferably, the third plastic material 13m comprises Polycarbonate (PC), Acrylonitrile Butadiene Styrene (ABS), a combination of PC/ABS, or Thermoplastic Polyurethane (TPU). In some embodiments, the third plastic material 13m may comprise light guides passing, reflecting, and/or blocking light. In one embodiment, the third plastic material 13m is a colored plastic material covering underlying layers 11,12, circuitry 15, and protecting SMD components. Alternatively, or in addition, other plastic materials having a higher solubility in the respective dissolving agent A as compared to the first plastic material 11m and/or the second plastic material 12m can be envisioned.

In some embodiments, the third plastic material 13m is recycled by means of dissolution in a dissolving agent A. For example, WO 2022/255873 discloses various dissolving agents to dissolve polycarbonate (PC) and/or other plastics such as acrylonitrile butadiene styrene (ABS). Other or further dissolving agents can be envisioned by a skilled person observing dissolution of different materials in a dissolving agent. In one embodiment, the first plastic material 11m comprises Polyethylene Naphtalate (PEN), the second plastic material 12m comprises Polybutylene Terephthalate (PBT), the third plastic material 13m comprises Polycarbonate (PC), and the dissolving agent A comprises cyclopentanone. Of course also other combinations of plastics and suitable dissolving agent can be envisaged. In some embodiments, a rate of dissolving is improved by heating the solution and/or dissolving agent A, e.g. above 40°C, preferably above 60°C up to 100°C, or more. Alternatively, or in addition, other low-temperature recycling method that retains the structural integrity of the recyclable package P can be envisioned.

In principle, the metal material 15m may be recovered from one or more recyclable packages P in various ways. Most efficiently, the metal material 15m may be recovered and/or isolated from the recyclable package P by means of thermal process. For example, a high-temperature recycling process such as (pyro)metallurgy may be used. In one embodiment, the metal material 15m comprises silver, copper or other valuable metals, e.g. precious metals. Preferably, the metal material 15m is recycled in a metallurgic process, e.g. in a combustion chamber. In another or further embodiment, copper exits the combustion chamber via a metal alloy stream to a subsequent process involving copper metallurgy. In yet another or further embodiment, silver leaves the combustion chamber in flue gases as silver oxide which is subsequently captured, dissolved, e.g. via leaching, and then deposited on an electrode through electrodeposition. Most preferably, the metal material 15m is recovered from a plurality of recyclable packages P in a single processing step, e.g. as shown in FIG 1C.

Also other or further ways of recovering the metal material may be envisaged, including one or more of: mechanical separation, chemical processes, thermal processes, electrochemical processes, physical separation, and manual dismantling. For example, in mechanical separation, the recyclable package(s) P are shredded into smaller pieces, allowing for the use of magnetic or eddy current separation to extract ferrous and nonferrous metals respectively. For example, chemical processes may involve solvent extraction to dissolve the plastic material, or acid leaching to dissolve the metal, both followed by appropriate separation and recovery steps. For example, thermal processes such as pyrolysis or incineration can decompose the plastic, leaving the metal material 15m intact or as a residue. For example, electrochemical processes, like electrolysis, can dissolve the metal in an electrolyte solution, facilitating its separation from the plastic. For example, physical separation techniques exploit differences in density, utilizing fluids where the plastic floats and the metal sinks, or air classification to segregate lighter plastic from heavier metals. In principle, manual dismantling is also an option, especially for larger recyclable package(s) P or when the embedded metal parts are readily accessible. These methods, either individually or in combination, may ensure efficient recovery of the metal material 15m from the recyclable package(s) P.

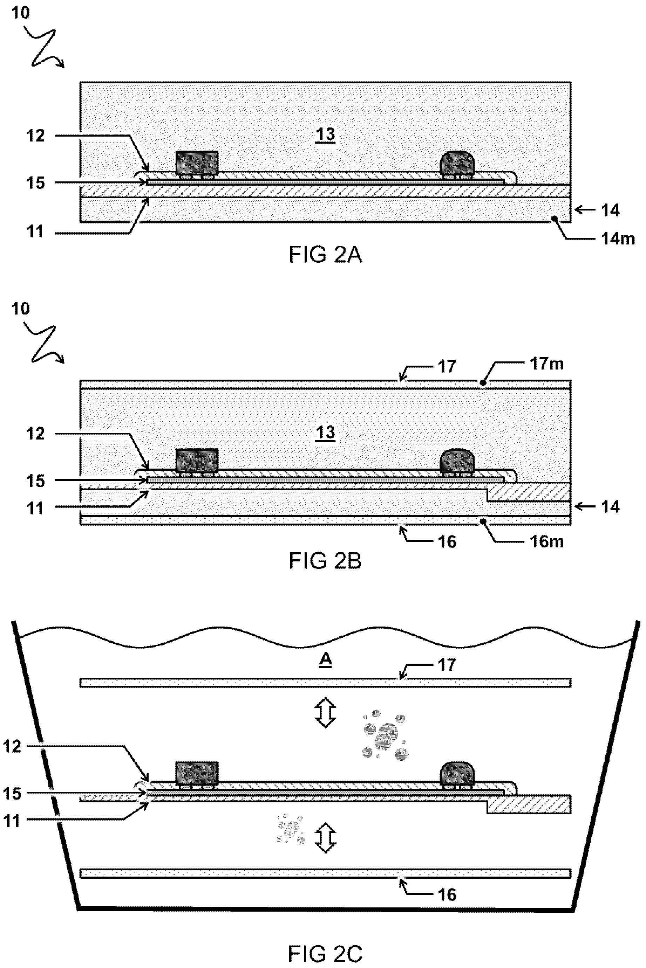

FIGs 2A-2C illustrate a method of recycling an electronic stack 10 provided with a reinforcement layer 14 comprising a fourth plastic material 14m arranged adjacent, e.g. subjacent, to a substrate layer 11 for reinforcing the structural integrity of the substrate layer 11. Preferably, the fourth plastic material 14m and the third plastic material 13m are substantially the same materials, e.g. having the same solubility in a respective dissolving agent A. In some embodiments, the fourth plastic material 14m comprises Polyurethane (PUR) configured to provide cosmetic (decorative) layer to in-mold electronics and also to function as anti-scratch and/or strength enhancing material. In one embodiment, the fourth plastic material 14m provides obscuring of cosmetic defects related to bonding of SMD components on the thermoplastic substrate, e.g. due to a mismatch in thermal expansion. In another or further embodiment, the fourth plastic material 14m increases the overall thickness of the product formed on a relatively thin substrate. Alternatively, or in addition, the fourth plastic material 14m and the third plastic material 13m are different materials having a comparable solubility in the respective dissolving agent A.

Preferably, the reinforcement layer 14, formed of the fourth plastic material 14m, that is dissolvable in the dissolving agent A, is thicker than the substrate layer 11, formed of the first plastic material 11m, that is not solvable in the respective dissolving agent A. For example, the reinforcement layer 14 is thicker than the substrate layer 11 by a factor of 1.5, 5, up to 10 or more. In this way a relatively large portion of the electronic stack 10 may be removed before a subsequent recycling step.

In some embodiments, the reinforcement layer 14 is formed by co-extruding the first plastic material 11m with the fourth plastic material 14m for improving the structural strength of the substrate layer 11. In one embodiment, the substrate layer 11 is formed of a Poly(methyl methacrylate) (PMMA) material co-extruded with a Polycarbonate (PC) material. In another or further embodiment, the substrate layer 11 is co-extruded with ABS, PE, PP, HIPS, PVC, PETG, and/or TPE material co-extruded with Polycarbonate (PC) material. For example, this may result in a relatively rigid substrate. Alternatively, or in addition, the substrate layer 11 formed of a first plastic material 11m having a first solubility S1 is co-extruded with a fourth plastic material 14m having a second solubility S2 that is higher in a respective dissolving agent A as compared to the first solubility S1, e.g. a factor of two, ten, hundred or more higher. Preferably, the fourth plastic material 14m of the co-extruded reinforcement layer 14 is removed by applying the dissolving agent A to the electronic stack 10 for isolating the recyclable package P comprising the first plastic material 11m. In other or further embodiments, the substrate layer 11 is not co-extruded, e.g. formed of Polyethylene Terephtalate (PET). For example, this may result in a relatively flexible substrate. Flexible, yet structurally improved, substrates may also be formed by two flexible co-extruded layers.

In some embodiments, the substrate layer 11 and/or the encapsulation layer 12 is applied as a printed coating and/or thin film of the respective first and/or the second plastic material 11m, 12m to the respective layer 14,15. In another or further embodiments, e.g. as shown in FIG 2B, one or more additional layers 16,17 are applied subjacent to the reinforcement layer 14 and/or on top of the support layer 13. For example, the additional layers 16,17 are formed of a Polyurethane (PUR) coating. In one embodiment, the thickness of the Polyurethane (PUR) coating layer is ranging from one hundred to one thousand micrometers, preferably up to two to five hundred micrometers.

In other or further embodiments, e.g. as shown in FIG 2C, the dissolving agent A is applied to the electronic stack 10 for removing the support layer 13 (not shown), at least a portion of the reinforcement layer 14 (not shown), and the additional layers 16,17, thereby isolating the recyclable package P comprising the circuit layer 15 embedded between the substrate layer 11 and the encapsulation layer 12. Advantageously, the weight percentage of the metal material 15m in the recyclable package P may be higher as compared to the weight percentage of the metal material 15m in the electronic stack 10, e.g. by at least a factor two, three, five, ten, up to a factor one hundred, or more. The higher the relative amount of metal in the recyclable package P, the more economically said metal material may be recovered.

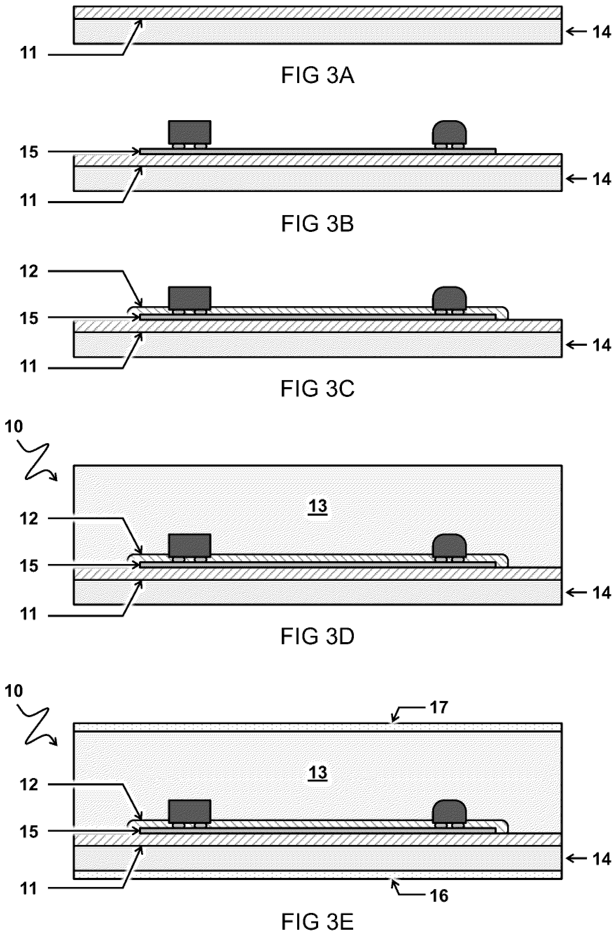

FIGs 3A-3E illustrate a method of manufacturing an electronic stack 10. FIG 3A shows providing a substrate layer 11 formed of a first plastic material 11m. FIG 3B shows applying a circuit layer 15 formed of a metal material 15m arranged on the substrate layer 11. FIG 3C shows applying an encapsulation layer 12 formed of a second plastic material 12m covering the circuit layer 15. In some embodiments, the circuit layer 15 is embedded between the substrate layer 11 and the encapsulation layer 12 to form a recyclable package P. In one embodiment, e.g. as shown in FIG 3D, a support layer 13 formed of a third plastic material 13m covering at least one side of the recyclable package P is applied. In other or further embodiments, e.g. as shown in FIGs 3D-3E the substrate layer 11 is provided on top of a reinforcement layer 14. In one embodiment, the first plastic material 11m of the substrate layer 11 and the fourth plastic material 14m of the reinforcement layer 14 are co-extruded to form a co-extruded film layer. In another or further embodiment, the third plastic material 13m comprises Thermoplastic Polyurethane (TPU) for improving the flexibility of the electronic stack 10, e.g. flexile sensors, lighting foils, health monitoring or treatment patches. In yet other or further embodiments, e.g. as shown in FIG 3E, one or more additional layers 16,17 are applied subjacent to the reinforcement layer 14 and/or on top of the support layer 13. In some embodiments, solubility of at least one of the additional layer materials 16m, 17m in a dissolving agent A is lower than solubility of the third plastic material 13m and/or the fourth plastic material 14m in the respective dissolving agent A, e.g. a factor of two, ten, hundred or more higher.

In some embodiments (not shown), the electronic stack 10 is repaired by applying a dissolving agent A to the electronic stack 10 for removing the support layer 13 and isolating the recyclable package P comprising the circuit layer 15 embedded between the substrate layer 11 and the encapsulation layer 12. In one embodiment, the surface-mounted-devices (15c) disposed on the circuit layer (15) are repaired and/or replaced. At least one side of the repaired recyclable package P is subsequently covered by a third plastic material 13m to restore the support layer 13.

In other or further embodiments, the recyclable electronic stack 10 comprises a substrate layer 11 formed of a first plastic material 11m, a circuit layer 15 formed of a metal material 15m arranged on the substrate layer 11, and an encapsulation layer 12 formed of a second plastic material 12m covering the circuit layer 15. In one embodiment, the circuit layer 15 is embedded between the substrate layer 11 and the encapsulation layer 12 to form a recyclable package P. In another or further embodiment, the electronic stack 10 comprises a support layer 13 formed of a third plastic material 13m covering at least one side of the recyclable package P. In some embodiments, the solubility of the third plastic material 13m in a respective dissolving agent A is substantially higher as compared to the solubility of the first plastic material 11m and/or the second plastic material 12m.

In one embodiment, the substrate layer 11 and/or the encapsulation layer 12 have a thickness ranging from five to sixty micrometers, preferably from ten to thirty micrometers, up to one hundred micrometers or more. In another or further embodiment, the support layer 13 has a thickness ranging from quarter to ten millimeters, preferably from half to five millimeters, up to fifty millimeters or more. In yet another or further embodiment, the circuit layer 15 has a thickness ranging from one to fifty micrometers, preferably from eight to ten micrometers, up to one hundred micrometers or more. In yet another or further embodiment, the reinforcement layer 14 has a thickness ranging from fifty to one thousand micrometers, preferably from one hundred to five hundred micrometers, up to two thousand micrometers or more. In yet another or further embodiment, the additional layers 16,17 have a thickness ranging from one hundred to one thousand micrometers, preferably less than five hundred micrometers, or less than two hundred micrometers;

In some embodiments, the circuit layer 15 comprises surface-mounted-devices 15c. In one embodiment, the encapsulation layer 12 covers the surface-mounted-devices 15c disposed on the circuit layer 15. In other or further embodiments, the additional layers 16,17 comprise over-molded coating, e.g. decorative, tactile, or anti-scratch layers. In yet other or further embodiments, the additional layers 16,17 comprise a window for enabling functionality of the surface-mounted-devices 15c disposed on the circuit layer 15, e.g. a transparent window for transmission of light from a light-emitting diode.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A method of recycling an electronic stack (10),
the electronic stack (10) comprising
a substrate layer (11) formed of a first plastic material (11m);
a circuit layer (15) formed of a metal material (15m) arranged on the substrate layer (11);
an encapsulation layer (12) formed of a second plastic material (12m) covering the circuit layer (15);
wherein the circuit layer (15) is embedded between the substrate layer (11) and the encapsulation layer (12) to form a recyclable package (P); and
a support layer (13) formed of a third plastic material (13m) covering at least one side of the recyclable package (P);
the method comprising
providing a dissolving agent (A) formulated to dissolve the third plastic material (13m) while essentially leaving the first plastic material (11m) and the second plastic material (12m) intact;
applying the dissolving agent (A) to the electronic stack (10) for removing the support layer (13) and isolating the recyclable package (P) comprising the circuit layer (15) embedded between the substrate layer (11) and the encapsulation layer (12).

2. The method according to the preceding claim comprising recovering the metal material (15m) of the circuit layer (15) from a plurality of recyclable packages (P) in a single processing step.

3. The method according to any of the preceding claims comprising recovering the metal material (15m) of the circuit layer (15) from one or more recyclable packages (P) using a thermal and/or metallurgic process.

4. The method according to any of the preceding claims, wherein the electronic stack (10) is provided with a reinforcement layer (14) comprising a fourth plastic material (14m) arranged subjacent to the substrate layer (11) for reinforcing the structural integrity of the substrate layer (11).

5. The method according to the preceding claim, wherein the reinforcement layer (14) is formed by co-extruding the first plastic material (11m) with the fourth plastic material (14m).

6. The method according to any of the two preceding claims, wherein the fourth plastic material (14m) of the reinforcement layer (14) is removed by applying the dissolving agent (A) to the electronic stack (10) for isolating the recyclable package (P) comprising the first plastic material (11m).

7. The method according to any of the three preceding claims, wherein the substrate layer (11) and/or the encapsulation layer (12) is applied as a printed coating and/or thin film of the respective first and/or the second plastic material (11m, 12m) to the respective layer (14,15).

8. The method according to any of the four preceding claims, wherein one or more additional layers (16,17) are applied subjacent to the reinforcement layer (14) and/or on top of the support layer (13); wherein solubility of the additional layer materials (16m, 17m) in a dissolving agent (A) is lower than solubility of the third plastic material (13m) and/or the fourth plastic material (14m) in the respective dissolving agent (A).

9. The method according to any of the five preceding claims comprising applying the dissolving agent (A) to the electronic stack (10) for removing the support layer (13), at least a portion of the reinforcement layer (14), and the additional layers (16,17), thereby isolating the recyclable package (P) comprising the circuit layer (15) embedded between the substrate layer (11) and the encapsulation layer (12).

10. The method according to any of the preceding claims, wherein a weight percentage of the metal material (15m) in the recyclable package (P) is higher than a weight percentage of the metal material (15m) in the electronic stack (10).

11. A method of manufacturing an electronic stack (10), the method comprising
providing a substrate layer (11) formed of a first plastic material (11m);
applying a circuit layer (15) formed of a metal material (15m) arranged on the substrate layer (11);
applying an encapsulation layer (12) formed of a second plastic material (12m) covering the circuit layer (15);
wherein the circuit layer (15) is embedded between the substrate layer (11) and the encapsulation layer (12) to form a recyclable package (P); and
applying a support layer (13) formed of a third plastic material (13m) covering at least one side of the recyclable package (P);
wherein the third plastic material (13m) is dissolvable in a dissolving agent (A), which dissolving agent (A) leaves the first plastic material (11m) and second plastic material (12m) intact.

12. The method according to the preceding claim, wherein the substrate layer (11) is provided on top of a reinforcement layer (14) comprising a fourth plastic material (14m); wherein the first plastic material (11m) of the substrate layer (11) and the fourth plastic material (14m) of the reinforcement layer (14) are co-extruded to form a co-extruded film layer.

13. A method of repairing the electronic stack (10) manufactured according to any of the three preceding claims, the method comprising
applying the dissolving agent (A) to the electronic stack (10) for removing the support layer (13) and isolating the recyclable package (P) comprising the circuit layer (15) embedded between the substrate layer (11) and the encapsulation layer (12);
repairing the isolated recyclable package (P); and
covering at least one side of the repaired recyclable package (P) by a third plastic material (13m) to restore the support layer (13).

14. An electronic stack (10) comprising
a substrate layer (11) formed of a first plastic material (11m);
a circuit layer (15) formed of a metal material (15m) arranged on the substrate layer (11);
an encapsulation layer (12) formed of a second plastic material (12m) covering the circuit layer (15);
wherein the circuit layer (15) is embedded between the substrate layer (11) and the encapsulation layer (12) to form a recyclable package (P); and
a support layer (13) formed of a third plastic material (13m) covering at least one side of the recyclable package (P);
wherein a solubility of the third plastic material (13m) in a respective dissolving agent (A) is substantially higher as compared to the solubility of the first plastic material (11m) and/or the second plastic material (12m) in the respective dissolving agent (A).

15. The electronic stack (10) according to the preceding claim, wherein
the first plastic material (11m) and/or the second plastic material (12m) comprises one or more of Polyethylene Terephthalate (PET), Polyethylene Naphtalate (PEN), Poly(methyl methacrylate) (PMMA), or Polybutylene Terephthalate (PBT), Polyimide (PI), Polyether Ether Keton (PEEK), and/or Polyamide (PA); and
the third plastic material (13m) comprises one or more of Polycarbonate (PC), Acrylonitrile Butadiene Styrene (ABS), Thermoplastic Polyurethane (TPU), Polyethylene (PE), and/or Polypropylene (PP).
